# EUROPÄISCHE PATENTSCHRIFT

(11) **EP 1 327 891 B1**
(45) Veröffentlichungstag und Bekanntmachung des Hinweises auf die Patenterteilung: **05.09.2012**
(21) Anmeldenummer: 02025379.5
(22) Anmeldetag: 14.11.2002
(51) Int. Cl.: G01R 33/09

(54) **Vorrichtung zur Messung eines Magnetfeldes, Magnetfeldsensor und Strommesser**
Device for measuring a magnetic field, magnetic field sensor and current sensor
Dispositif de mesure d'un champs magnétique, capteur de champs magnétique et ampèremètre

(30) Priorität: 10.01.2002 DE 10200600
(43) Veröffentlichungstag der Anmeldung: 16.07.2003
(73) Patentinhaber: ROBERT BOSCH GMBH, 70442 Stuttgart (DE)
(72) Erfinder: Ernst, Stephan, 73760 Ostfildern (DE)

(56) Entgegenhaltungen:
- EP-A2- 0 738 896
- DE-A1- 4 101 945
- DE-A1- 4 314 539

## Beschreibung

### Stand der Technik

Es ist allgemein bekannt, zur Magnetfeldmessung verschiedene Sensorprinzipien zu verwenden. Dabei werden Konzepte danach unterschieden, ob das zu messende Magnetfeld senkrecht oder parallel zur Sensoroberfläche anliegt. Sensoren mit einem Messmagnetfeld senkrecht zur Sensoroberfläche sind beispielsweise Hall-Sensoren oder MagFETs. Messmagetfelder parallel zur Oberfläche messen beispielsweise der laterale Magnetotransistor oder XMR-Sensoren, d.h. auf dem GMR- oder AMR-Prinzip (giant bzw. anisotropic magnetoresistance) beruhende Schichten.

Es ist weiterhin allgemein bekannt, eine berührungsfreie, verlustarme und potentialfreie Messung der elektrischen Stromstärke durch aktive Magnetfeldmessungen durchzuführen. In den meisten Anwendungen wird eine sehr genaue Strommessung über mehrere Größenordnungen und eine möglichst geringe Störanfälligkeit gefordert, wobei der Einsatzort der dazu benötigten hochempfindlichen Sensoren im allgemeinen stark elektromagnetisch belastet ist, beispielsweise durch Stör- und Streufelder von benachbarten Stromleitern oder durch die rotierenden Magnetfelder in der Umgebung eines Generators. Folglich ist die Diskriminierung zwischen dem zu messenden Magnetfeld und den parasitären Streufeldern der Umgebung sehr schwer, da selbst bei sehr hohen Strömen von einigen 100A die den Leiter umgebenden Magnetfelder oft nur in der Größenordnung weniger Millitesla liegen. Die Feldstärke ist damit oft nur unwesentlich größer als die der Streufelder. Es ist daher allgemein bekannt, sehr empfindliche und gut gegen Störungen abgeschirmte Magnetfeldsensoren zu verwenden, wobei oftmals das Magnetfeld zusätzlich durch einen sogenannten Magnetkreis konzentriert und so für die Messung verstärkt wird.

Bei schwachen zu messenden Magnetfeldern werden insbesondere Flusskonzentratoren aus magnetisch aktivem Material, insbesondere Ferromagnete, Nickel, Kobalt, eingesetzt, welche die Magnetfelder verstärken können. Hierbei ist es wichtig, den Luftspalt, in dem das Sensorelement zur Messung des verstärkten B-Feldes eingefügt werden muss, so klein wie möglich zu halten. Hierfür eignen sich insbesondere Sensoren, die Magnetfelder senkrecht zur Sensoroberfläche messen.

Aus der DE 43 14 539 A1 ist ein MR-Sensor bekannt, bei dem in die Oberfläche einer (100)-Kristallfläche des Siliziumsubstrats eine Ausnehmung eingearbeitet worden ist, so dass wenigstens eine Seitenwand der Ausnehmung durch eine (111)-Kristallfläche des Si gebildet wird. Zur Erzeugung des M R-Sensors wird auf die Seitenwand ein MR-Sensorelement angeordnet.

Aus der EP 738 896 A2 ist ein M R-Sensor bekannt, der auf einem Substrat eine M R-Schicht aufweist. Auf dieser MR-Schicht werden Strukturen aufgebracht, die die eigentliche Erfassung des longitudinalen Magnetfelds durch die MR-Schicht verbessert.

### Vorteile der Erfindung

Die erfindungsgemäße Vorrichtung, der erfindungsgemäße Magnetfeldsensor und der erfindungsgemäße Strommesser mit den Merkmalen der nebengeordneten Ansprüche hat demgegenüber den Vorteil, dass die Vorrichtung XMR-Sensoren mit einer Messrichtung senkrecht zur Sensoroberfläche verfügbar macht, die sich insbesondere zur Verwendung mit Flusskonzentratoren eignen, d.h. bei denen ein optimal kleiner Luftspalt vorgesehen ist Weiterhin ist von Vorteil, dass der Sensor mit einer kleineren Fläche, d.h. kleiner bzw. kompakter, herstellbar ist. Weiterhin ist von Vorteil, dass ein höherer Wirkungsgrad durch die Ausnutzung von mehreren Magnetfeldkomponenten erreichbar ist. Weiterhin ist es vorteilhaft möglich, die maximale Magnetfelderhöhung von geeigneten Stromleitergeometrien durch die Ausrichtung der Sensorstrukturen entsprechend des Feldlinienverlaufs zu nutzen. Vorteilhaft ist weiterhin, dass erfindungsgemäß ein 180°-Magnetfeldsensor durch eine entsprechende Anordnung der empfindlichen Schichten in unterschiedlichen Winkeln auf der Sensoroberfläche und in unterschiedlichen Winkeln zur Sensoroberfläche möglich wird, der erst die Messung bestimmter Feldkomponenten in einem einzigen Sensor ermöglicht. Weiterhin ermöglicht die erfindungsgemäße Vorrichtung in vorteilhafter Weise die Diskriminierung zwischen Nutz- und Störfeldern. Bei der erfindungsgemäßen Vorrichtung ist es weiterhin vorteilhaft möglich, eine vereinfachte Herstellung von XMR-Multilayerstrukturen in wenigen Arbeitsschritten zu erreichen.

Durch die in den Unteransprüchen aufgeführten Maßnahmen sind vorteilhafte Weiterbildungen und Verbesserungen der im Hauptanspruch angegebenen Vorrichtung möglich.

Besonders vorteilhaft ist es, dass die Struktur als ein Graben und/oder als eine Erhebung und/oder als eine Kombination eines Grabens mit einer Erhebung vorgesehen ist, wobei die Struktur relativ zur Hauptsubstratebene schräge und/oder senkrechte Wände aufweist. Hierdurch ergibt sich die Möglichkeit, die magnetfeldsensitiven Schichten in verschiedenen Winkeln anzubringen in besonders einfacher Weise.

Weiterhin ist es vorteilhaft, dass das Substrat eine Hauptsubstratebene aufweist, wobei die Mehrzahl von Hauptdetektionsrichtungen parallel zur Hauptsubstratebene vorgesehen sind. Insbesondere hierdurch ist die Darstellung eines 180°-B-Feldsensors möglich, indem die magnetfeldsensitiven Schichten entweder in der Ebene der Sensoroberfläche in unterschiedlichen Winkeln zu einer Kante der Substratoberfläche oder aber in unterschiedlichen Winkeln zur Sensoroberfläche angeordnet sind. Damit ergibt sich in besonders einfacher Weise die Möglichkeit der Messung bestimmter Feldkomponenten mit einem hohen Wirkungsgrad, nämlich die Messung derjenigen Feldkomponenten, welche jeweils parallel zu einer der magnetfeldsensitiven Schichten verläuft.

Weiterhin ist es vorteilhaft, dass das Magnetfeld eine Nutzfeldkomponente und eine Störfeldkomponente aufweist, wobei die Hauptdetektionsrichtung wenigstens einer Widerstandsschicht senkrecht auf die Nutzfeldkomponente oder senkrecht auf die Störfeldkomponente vorgesehen ist. Hierdurch ist es möglich, die Nutzfeldkomponente von der Störfeldkomponente zu trennen.

Weiterhin ist es vorteilhaft, dass als Widerstandsschicht eine GMR-Schicht (giant magnetoresistance) oder eine AMR-Schicht (anisotropic magnetoresistance) oder eine Kombination einer GMR-Schicht und einer AMR-Schicht vorgesehen ist.

### Zeichnung

Ausführungsbeispiele der Erfindung sind in der Zeichnung dargestellt und in der nach folgenden Beschreibung näher erläutert. Es zeigen
Figur 1 eine schematische Skizze einer erfindungsgemäßen Vorrichtung mit verschiedenen Beispielen von magnetfeldabhängigen Widerstandsschichten auf einem Substrat bzw. einem Chip,
Figur 2 eine schematische Skizze einer erfindungsgemäßen Vorrichtung mit zwei Beispielen von magnetfeldabhängigen Widerstandsschichten auf einem Chip und der sensitiven Magnetfeldrichtungen des Sensors und
Figur 3 eine erfindungsgemäßen Vorrichtung mit mehreren senkrecht zur Hauptsubstratebene angeordneten magnetfeldabhängigen Widerstandsschichten auf einem Substrat.

### Beschreibung

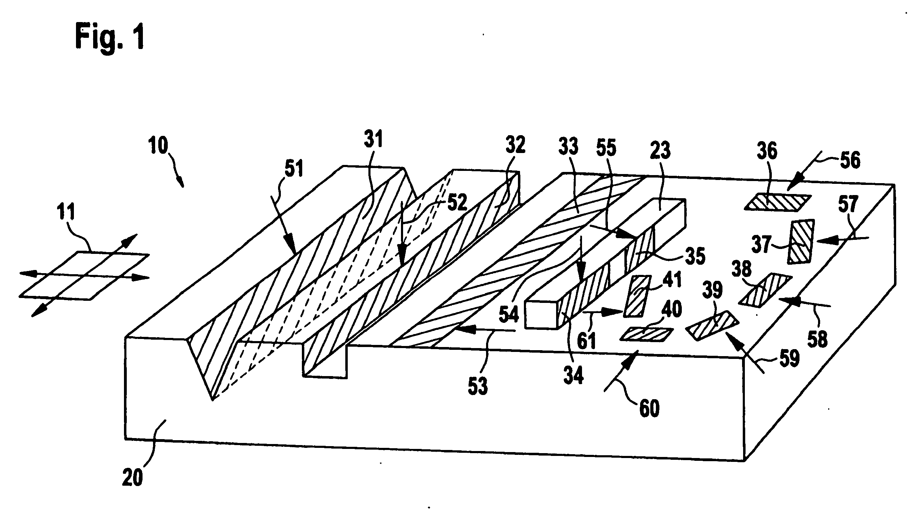

In Figur 1 ist eine erfindungsgemäße Vorrichtung 10 dargestellt. Die Vorrichtung 10 umfaßt ein Substrat 20, welches insbesondere aus Halbleitermaterial, beispielsweise Silizium, vorgesehen ist. Das Substrat 20 hat eine Hauptsubstratebene, welche in Figur 1 mit dem Bezugszeichen 11 bezeichnet ist. Die Oberfläche des Substrats 20 ist erfindungsgemäß derart strukturiert, dass entweder verschiedene Flächen vorgesehen sind, welche nichtparallel zur Hauptsubstratebene 11 vorgesehen sind; dies bedeutet, dass die Ebenen der verschiedenen Flächen spitzwinklig oder rechtwinklig auf die Hauptsubstratebene stehen. Alternativ oder zusätzlich ist es erfindungsgemäß vorgesehen, dass die Oberfläche des Substrats 20 so strukturiert ist, dass verschiedenen Flächen parallel zur Hauptsubstratebene 11 vorgesehen sind, wobei jedoch diese Flächen im wesentlichen rechteckig oder zumindest länglich vorgesehen sind, wobei die solchermaßen vorgesehenen Flächen eine Hauptausdehnungsrichtung aufweisen. Die verschiedenen Flächen dienen der Aufnahme von magnetfeldsensitiven Schichten, welche im folgenden auch als XMR-Schichten bzw. Widerstandsschichten bezeichnet werden. Der Begriff XMR-Schicht drückt dabei aus, dass es sich bei der Widerstandsschicht entweder um eine AMR-Schicht oder um eine GMR-Schicht oder um eine Kombination einer AMR-Schicht mit einer GMR-Schicht handelt. Solche XMR-Schichten bzw. Widerstandsschichten weisen jeweils eine Hauptdetektrionsrichtung auf, in welcher sie am sensitivsten auf Magnetfeldkomponenten ansprechen. Die Hauptdetektionsrichtung liegt dabei immer in der Ebene der XMR-Schicht und ist senkrecht auf die Hauptausdehnungsrichtung ausgerichtet.

Die Strukturierung der Oberfläche des Substrats 20 wird im folgenden auch als Trench-XMR-Struktur bezeichnet. Zur Erzeugung solcher Trench-XMR-Strukturen wird in das Substrat mit aus der Halbleitertechnik bekannter Technologie, insbesondere bekannten Ätzverfahren, beispielsweise nasschemisch oder mittels Plasmaätzverfahren, eine Oberflächenstruktur, insbesonder mit Gräben und dergleichen, mit dem gewünschten Winkel und der gewünschten Form, insbesondere V-Nut, U-förmiger Graben und dergleichen, geätzt. Das Substrat ist dabei beispielsweise als Siliziumoder Germaniumhalbleiter, als III-V-Halbleiter, als II-VI-Halbleiter oder als ein Mischtyp vorgesehen. Das Substrat 20 ist erfindungsgemäß als ASIC, als Halbleiterplättchen oder auch aus einem anderen Material, wie beispielsweise Keramic, DBC oder dergleichen, vorgesehen. Es ist erfindungsgemäß auch vorgesehen, eine bereits durch eine Vorbearbeitung vorhandene Topologie bzw. Stukturierung der Substratoberfläche, beispielsweise eine Stufe oder dergleichen, zu benutzen.

Durch Sputtern oder Bedampfen, durch galvanische Abscheidung oder ein anderes geeigntetes Verfahren kann nun die XMR-Schicht auf dem Substrat abgeschieden und anschließend mittels fotolithographischen Prozessen strukturiert werden. Nach dem anschließenden Ätzschritt verbleiben die gewünschten XMR-Strukturen auf dem Substrat 20, welches im folgenden auch einfach als Chip 20 bezeichnet wird, bestehen, während die restlichen Schichten entfernt werden.

Durch Kombination unterschiedlicher Winkel der XMR-Schichten in der Hauptsubstratebene 11 des Substrats 20 bzw. auch außerhalb der Hauptsubstratebene 11 des Substrats 20 lassen sich 3D-XMR-Sensoren darstellen, die den Vorteil aufweisen, auch auf Magnetfeldkomponenten sensitiv zu sein, die außerhalb der Hauptchipebene verlaufen. Dies kann erfindungsgemäß bis zur 3D-Messfähigkeit ausgedehnt werden, d.h. es wird ein Magnetfeldsensor vorgeschlagen, welcher auf Magnetfeldkomponenten jeglicher Richtung sensitiv ist.

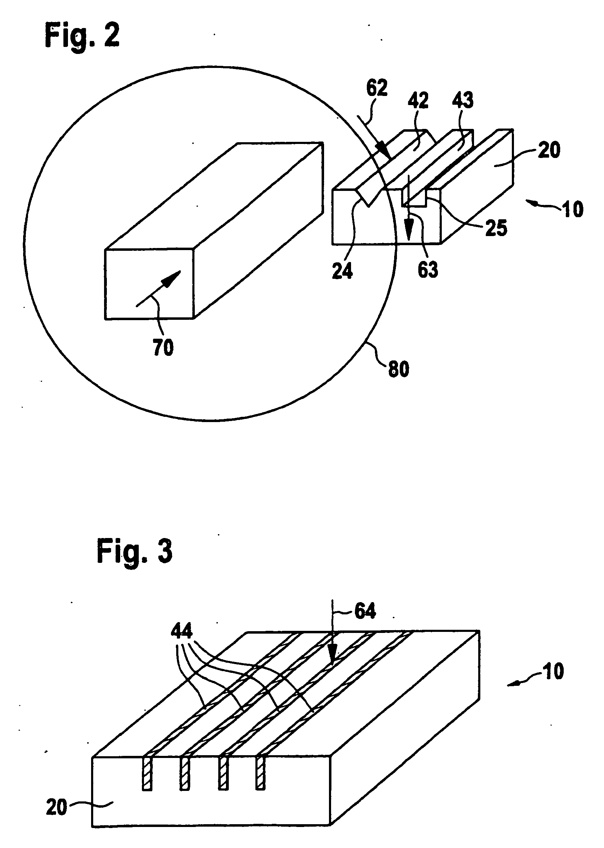

In Figur 1 sind im einzelnen eine erste XMR-Schicht 31 vorgesehen, welche auf einer der Wandseiten einer V-Nut im Substrat 20 vorgesehen ist. Mit der ersten XMR-Schicht 31 korrespondiert eine erste Hauptdetektionsrichtung 51. Weiterhin ist in Figur 2 eine zweite XMR-Schicht 32 vorgesehen, welche auf einer der Wandflächen eines U-förmigen Grabens auf der Oberfläche des Substrates 20 vorgesehen ist. Mit der zweiten XMR-Schicht 32 korrespondiert eine zweite Hauptdetektionsrichtung 52.
Die erste und zweite XMR-Schicht 31, 32 erstreckt sich insbesondere über die gesamte Breite des Substrats in dem Maße, in dem sich auch die V-Nut bzw. der U-förmige Graben im Beispiel der Figur 1 über die gesamte Breite des Substrats erstreckt. Erfindungsgemäß ist jedoch auch vorgesehen, dass sich eine XMR-Schicht nur über einen Teil eines solchen Grabens bzw. einer solchen Nut erstreckt. Weiterhin ist in Figur 1 eine dritte XMR-Schicht 33 vorgesehen, welche sich in der Hauptsubstratebene 11 befindet und sich ebenfalls über die gesamte Breite des Substrats 20 erstreckt - d.h. in der Richtung der Breite des Substrats 20 ist die Hauptausdehnungsrichtung der dritten XMR-Schicht vorgesehen - , wobei die Ausdehnung der dritten XMR-Schicht 33 in hierzu orthogonaler Richtung weitaus geringer ist. Die hierzu korrespondierende dritte Hauptdetektionsrichtung 53 ist entsprechend in der Hauptsubstratebene 11 und senkrecht zur Hauptausdehnungsrichtung der XMR-Schicht orientiert.

Weiterhin ist in Figur 1 eine vierte XMR-Schicht 34 vorgesehen, welche auf einer der Seitenwände einer quaderförmigen Erhebung 23 auf dem Substrat 20 vorgesehen ist. Die vierte XMR-Schicht 34 ist dabei im wesentlichen - wenn man von der Dicke der XMR-Schicht absieht - als senkrecht angeordnetes Rechteck auf der Seitenwand der Erhebung 23 vorgesehen, wobei die Kante des Rechtecks mit der größeren Kantenlänge parallel zur Substratoberfläche verläuft. Die hierzu korrespondierende vierte Hauptdetektionsrichtung 54 steht im wesentlichen senkrecht auf die Hauptsubstratebene 11.

Ebenfalls auf der Seitenwand der Erhebung 23 ist eine fünfte XMR-Schicht 35 angeordnet, wobei jedoch im Gegensatz zur vierten XMR-Schicht 34 die Hauptausdehnungsrichtung der fünften XMR-Schicht 35 zwar in einer Ebene senkrecht zur Hauptsubstratebene 11 verläuft - weil die Seitenwand im Beispiel der Erhebung 23 ebenfalls senkrecht zur Hauptsubstratebene 20 verläuft -, wobei jedoch die Hauptausdehnungsrichtung gegenüber der Hauptsubstratebene 11 geneigt vorgesehen ist. Dies wird beispielsweise dadurch erreicht, dass die senkrechten Begrenzungskanten der fünften XMR-Schicht 35 in der Ebene der Seitenwand geneigt vorgesehen sind und eine im wesentlichen rautenförmige Form der fünften XMR-Schicht 35 ergeben. Entsprechend steht die hierzu korrespondierende fünfte Hauptdetektionsrichtung 55 wiederum in der Ebene der Seitenwand der Erhebung 23 senkrecht auf die Hauptausdehnungsrichtung.

Weiterhin sind in Figur 1 eine sechste XMR-Schicht 36, eine siebente XMR-Schicht 37, eine achte XMR-Schicht 38, eine neunte XMR-Schicht 39, eine zehnte XMR-Schicht 40 und eine elfte XMR-Schicht 41 vorgesehen, welche sämtlich in der Hauptsubstratebene 11 angeordnet sind. Jede der sechsten bis elften XMR-Schicht 36-41 ist im Beispiel der Figur 1 als Rechteck vorgesehen, wobei jeweils die längere der Kanten des Rechtecks die Hauptausdehnungsrichtung der XMR-Schichten 36-41 angibt. Die sechste bis elfte XMR-Schicht 36-41 ist in Figur 1 in der Hauptsubstratebene 11 derart angeordnet, dass zwischen dem Rechteck der sechsten XMR-Schicht 36 und den Rechtecken bzw. den Hauptausdehnungsrichtungen der weiteren XMR-Schichten 37-41 ein immer größerer Winkel in der Hauptsubstratebene 11 vorgesehen ist. Die Winkelschritte können von einer XMR-Schicht zur nächsten gleichbleibend oder variierend vorgesehen sein. Entsprechend ergeben sich ausgehend von der sechsten Hauptdetektionsrichtung 56 der sechsten XMR-Schicht 36 zu den Hauptdetektionsrichtungen 57-61 der siebten bis elften XMR-Schichten 36-41 immer größere Winkel. Durch die einzelne Ansteuerung bzw. Ausmessung einzelner XMR-Schichten in der Hauptsubstratebene 11 ist es daher möglich winkelaufgelöst ein zu messendes Magnetfeld zu bestimmen.

In Figur 2 ist wiederum das erfindungsgemäße Substrat 20 und die erfindungsgemäße Vorrichtung 10 dargestellt. Die Substratoberfläche der Vorrichtung 10 in Figur 2 trägt eine V-Nut 24 und einen U-förmigen Graben 25. Eine zwölfte XMR-Schicht 42 ist auf einer der Wände der V-Nut 24 angeordnet. Eine dreizehnte XMR-Schicht 43 ist auf einer der Seitenwände des U-förmigen Grabens 25 angeordnet. Die zwölfte XMR-Schicht 42 weist eine mit ihr korrespondierende zwölfte Hauptdetektionsrichtung 62 auf und die dreizehnte XMR-Schicht 43 weist eine mit ihr korrespondierende dreizehnte Hauptdetektionsrichtung 63 auf. In Figur 2 ist weiterhin ein stromführender Leiterabschnitt 70 dargestellt, wobei die Richtung des Stromflusses durch ein Pfeil im Leiterabschnitt 70 dargestellt ist. Durch den Stromfluss im Leiterabschnitt 70 wird ein Magnetfeld erzeugt, welches durch eine geschlossene Magnetfeldlinie in Figur 2 dargestellt ist, welche mit dem Bezugszeichen 80 bezeichnet ist. Die Magnetfeldlinie 80 schneidet die in Figur 2 dargestellte Vorrichtung 10 so, dass im Bereich der zwölften XMR-Schicht 42 die Magnetfeldlinie 80 etwa parallel zu der zwölften Hauptdetektionsrichtung 62 verläuft. Durch eine zusätzliche und in Figur 2 nicht dargestellte XMR-Schicht (z.B. auf der gegenüberliegenden Seite der V-Nut), deren Hauptdetektionsrichtung senkrecht zu der Magnetfeldlinie 80 orientiert vorzustellen wäre, ist es - beim Vorhandensein eines über die als zu messendes Nutzmagnetfeld aufgefaßte Magnetfeldlinie 80 hinausgehendes Störmagnetfeld - erfindungsgemäß möglich, mittels der nicht dargestellten zusätzlichen XMR-Schicht ausschließlich das Störmagnetfeld zu messen. Hierdurch ist eine Trennung von Störmagnetfeld und Nutzmagnetfeld möglich. Ebenso ist es erfindungsgemäß möglich, eine der XMR-Schichten derart vorzusehen, dass diese senkrecht zu dem Störmagnetfeld steht und somit dieses nicht sensiert. In diesem Fall ist der Beitrag der Störfeldkomponente zum Messergebnis einer solchen XMR-Schicht gerade Null und es wird ausschließlich das Nutzmagnetfeld gemessen. Bei geeigneter Wahl der verschiedenen Sensierwinkel, d.h. der verschiedenen Hauptdetektionsrichtungen und einer genügend hohen Anzahl unterschiedlicher Winkel ist eine Teilunterdrückung von Störfeldern möglich.

In Figur 3 ist eine erfindungsgemäße Vorrichtung 10 mit dem Substrat 20 dargestellt. Die Oberfläche des Substrats 20 umfaßt bei der in Figur 3 dargestellten Figur eine Mehrzahl von nicht mit einem Bezugszeichen bezeichnete, vergleichsweise schmale Gräben, in welche jeweils eine XMR-Schicht derart eingebracht ist, dass die Gräben weitgehend durch die XMR-Schicht bzw. das XMR-Material ausgefüllt sind. Hierdurch entsteht in den - im Vergleich zu ihrer Tiefe und ihrer Längsausdehnung parallel zur Hauptsubstratebene 11 - schmalen Gräben jeweils eine vierzehnte XMR-Schicht 44, welche eine vierzehnte Hauptdetektionsrichtung 64 aufweist, welche senkrecht zur Hauptsubstratebene 11 steht. Auf diese Weise ist es möglich, Magnetfeldsensoren mit XMR-Schichten zu erhalten, welche in eine Magnetfeldrichtung sensitiv sind, die senkrecht auf die Hauptsubstratebene 11 steht. Dies ist insbesondere vorteilhaft bei der Verwendung der erfindungsgemäßen Vorrichtung 10 in einem Magnetfeldsensor mit einem Magnetkreis, weil so der Spalt des Magnetkreises, in welchen die Vorrichtung eingebracht werden muß, ähnlich klein gehalten werden kann wie beispielsweise bei anderen Magnetfeldsensoren, die auf Magnetfelder sensitiv reagieren, die senkrecht auf die Hauptsubstratebene stehen, wie beispielsweise Hall-Sensoren oder magFETs.

Die erfindungsgemäße Vorrichtung 10 ist insbesondere zur Verwendung als Magnetfeldsensor vorgesehen. Weiterhin ist die erfindungsgemäße Vorrichtung 10 und der Magnetfeldsensor insbesondere als Strommesser vorgesehen, wobei die Stromstärke derart bestimmt wird, dass die magnetische Wirkung des Stromflusses in einem Leiter am Ort der erfindungsgemäßen Vorrichtung bzw. am Ort des erfindungsgemäßen Magnetfeldsensors zur Bestimmung der Stromstärke herangezogen wird.

## Patentansprüche

1. Vorrichtung (10) zur Messung eines Magnetfeldes mit einem Substrat (20) und wenigstens einer auf einer Außenfläche des Substrats (20) angeordneten magnetfeldabhängigen Widerstandsschicht (31-44), wobei das Substrat (20) eine Hauptsubstratebene (11) aufweist, dass die wenigstens eine Widerstandsschicht (31-44) eine Hauptdetektionsrichtung (51-64) aufweist, wobei das Substrat (20) eine Struktur aufweist, die derart strukturiert ist, dass die Hauptdetektionsrichtung (51-64) rechtwinklig auf der Hauptsubstratebene (11) steht,
**dadurch gekennzeichnet, dass**
die Oberfläche des Substrats (20) für eine Hauptdetektionsrichtung (64) eine Mehrzahl von schmalen Gräben aufweist, in welche jeweils eine XMR-Schicht derart eingebracht ist, dass die Gräben weitgehend durch die XMR-Schicht bzw. das XMR-Material ausgefüllt sind.

2. Vorrichtung (10) nach Anspruch 1, **dadurch gekennzeichnet, dass** es sich bei der XMR-Schicht um eine Widerstandsschicht entweder
• aus einer AMR- oder einer GMR-Schicht oder
• einer Kombination aus einer AMR-Schicht mit einer GMR-Schicht handelt.

3. Vorrichtung (10) nach Anspruch 1, **dadurch gekennzeichnet, dass** die Vorrichtung (10) eine Sensorstruktur (10) aufweist, wobei die Struktur (10) relativ zur Hauptsubstratebene (11) senkrechte Wände aufweist.

4. Vorrichtung (10) nach Anspruch 1 zur Messung eines Magnetfeldes mit einem Substrat (20) und einer Mehrzahl von auf einer Außenfläche des Substrats (20) angeordneten magnetfeldabhängigen Widerstandsschichten (31-44), **dadurch gekennzeichnet, dass** die Mehrzahl von Widerstandsschichten (31-44) jeweils eine Hauptdetektionsrichtung (51-64) aufweisen, wobei die Hauptdetektionsrichtungen (51-64) der Mehrzahl von Widerstandsschichten (31-44) rechtwinklig aufeinander stehen.

5. Vorrichtung (10) nach Anspruch 4, **dadurch gekennzeichnet, dass** das Substrat (20) eine Hauptsubstratebene (11) aufweist, wobei die Mehrzahl von Hauptdetektionsrichtungen (51-64) parallel zur Hauptsubstratebene (11) vorgesehen sind.

6. Vorrichtung (10) nach einem der vorhergehenden Ansprüche, **dadurch gekennzeichnet, dass** das Magnetfeld eine Nutzfeldkomponente und eine Störfeldkomponente aufweist, wobei die Hauptdetektionsrichtung (51-64) wenigstens einer Widerstandsschicht (31-44) senkrecht auf die Nutzfeldkomponente oder senkrecht auf die Störfeldkomponente vorgesehen ist.

7. Vorrichtung (10) nach einem der vorhergehenden Ansprüche, **dadurch gekennzeichnet, dass** als Substrat (20) ein Halbleitersubstrat, insbesondere ein Siliziumsubstrat, ein Germaniumsubstrat, ein III-V-Halbleitersubstrat, ein II-VI-Halbleitersubstrat, ein Halbleiter-Mischsubstrat, oder ein Keramiksubstrat oder ein Dualbonded-Copper-Substrat vorgesehen ist.

8. Magnetfeldsensor mit einer Vorrichtung (10) nach einem der vorhergehenden Ansprüche.

9. Strommesser mit einer Vorrichtung (10) oder einem Magnetfeldsensor nach einem der vorhergehenden Ansprüche.

## Claims

1. Device (10) for measuring a magnetic field comprising a substrate (20) and at least one magnetic-field-dependent resistance layer (31-44) arranged on an outer surface of the substrate (20), wherein the substrate (20) has a main substrate plane (11), wherein the at least one resistance layer (31-44) has a main detection direction (51-64), wherein the substrate (20) has a structure which is structured in such a way that the main detection direction (51-64) is at right angles to the main substrate plane (11),
**characterized in that**
the surface of the substrate (20), for a main detection direction (64), has a plurality of narrow trenches, into each of which an XMR layer is introduced in such a way that the trenches are substantially filled by the XMR layer or the XMR material.

2. Device (10) according to Claim 1, **characterized in that** the XMR layer is a resistance layer composed either
• of an AMR or a GMR layer or
• a combination of an AMR layer with a GMR layer.

3. Device (10) according to Claim 1, **characterized in that** the device (10) has a sensor structure (10), wherein the structure has walls that are perpendicular relative to the main substrate plane (11).

4. Device (10) according to Claim 1 for measuring a magnetic field comprising a substrate (20) and a plurality of magnetic-field-dependent resistance layers (31-44) arranged on an outer surface of the substrate (20), **characterized in that** the plurality of resistance layers (31-44) each have a main detection direction (51-64), wherein the main detection directions (51-64) of the plurality of resistance layers (31-44) are at right angles with respect to one another.

5. Device (10) according to Claim 4, **characterized in that** the substrate (20) has a main substrate plane (11), wherein the plurality of main detection directions (51-64) are provided parallel to the main substrate plane (11).

6. Device (10) according to any of the preceding claims, **characterized in that** the magnetic field has a useful field component and a disturbing field component, wherein the main detection direction (51-64) of at least one resistance layer (31-44) is provided perpendicular to the useful field component or perpendicular to the disturbing field component.

7. Device (10) according to any of the preceding claims, **characterized in that** a semiconductor substrate, in particular a silicon substrate, a germanium substrate, a III-V semiconductor substrate, a II-VI semiconductor substrate, a semiconductor mixed substrate, or a ceramic substrate or a dual-bonded copper substrate, is provided as the substrate (20).

8. Magnetic field sensor comprising a device (10) according to any of the preceding claims.

9. Ammeter comprising a device (10) or a magnetic field sensor according to any of the preceding claims.

## Revendications

1. Dispositif (10) pour la mesure d'un champ magnétique, le dispositif présentant un substrat (20) et sur une surface extérieure du substrat (20) au moins une couche résistive (31, 44) dont la résistance dépend du champ magnétique,
le substrat (20) présentant un plan principal de substrat (11),
la ou les couches résistives (31-44) présentant une direction principale de détection (51, 64),
le substrat (20) présentant une structure telle que la direction principale de détection (51-64) est orientée perpendiculaire au plan principal (11) du substrat,
**caractérisé en ce que**
pour former une direction principale de détection (64), la surface du substrat (20) présente plusieurs sillons étroits dans chacun desquels une couche XMR est placée de telle sorte que les sillons soient largement remplis par la couche XMR ou le matériau XMR.

2. Dispositif (10) selon la revendication 1, **caractérisé en ce que** la couche XMR est une couche résistive constituée
d'une couche AMR ou d'une couche GMR, ou
d'une combinaison d'une couche AMR et d'une couche GMR.

3. Dispositif (10) selon la revendication 1, **caractérisé en ce que** le dispositif (10) présente une structure de capteur (10), la structure présentant, par rapport au plan principal (11) du substrat, des parois perpendiculaires.

4. Dispositif (10) selon la revendication 1, pour la mesure d'un champ magnétique, le dispositif présentant un substrat (20) et, sur une surface extérieure du substrat (20), une pluralité de couches résistives (31-44) dont la résistance dépend du champ magnétique, **caractérisé en ce que** la pluralité de couches résistives (31-44) présentent à chaque fois une direction principale de détection (51-64), les directions principales de détection (51-64) de la pluralité de couches résistives (31-44) étant disposées à angle droit par rapport aux autres.

5. Dispositif (10) selon la revendication 4, **caractérisé en ce que** le substrat (20) présente un plan principal (11) de substrat, la pluralité de directions principales de détection (51-64) étant prévues parallèlement au plan principal (11) du substrat.

6. Dispositif (10) selon l'une des revendications précédentes, **caractérisé en ce que** le champ magnétique présente une composante utile de champ et une composante parasite de champ, la direction principale de détection (51-64) d'au moins une couche résistive (31-44) étant perpendiculaire à la composante utile du champ ou perpendiculaire à la composante parasite du champ.

7. Dispositif (10) selon l'une des revendications précédentes, **caractérisé en ce qu'**il présente comme substrat (20) un substrat semi-conducteur, en particulier un substrat de silicium, un substrat de germanium, un substrat semi-conducteur III-V, un substrat semi-conducteur II-VI, un substrat semi-conducteur mixte, un substrat céramique ou un substrat de cuivre à double liaison.

8. Détecteur de champ magnétique doté d'un dispositif (10) selon l'une des revendications précédentes.

9. Dispositif de mesure de courant doté d'un dispositif (10) ou d'un détecteur de champ magnétique selon l'une des revendications précédentes.
